# FASCICULE DE BREVET EUROPEEN

(11) **EP 2 845 245 B1**
(45) Date de publication et mention de la délivrance du brevet: **01.02.2017**
(21) Numéro de dépôt: 13722327.7
(22) Date de dépôt: 30.04.2013
(51) Int. Cl.: H01M 2/10, H01B 19/00, H01G 2/02, H05K 5/02, H01M 2/20, H01M 10/42, H05K 5/00

(54) **DISPOSITIF POUR LE MAINTIEN D'ENSEMBLE DE STOCKAGE D'ENERGIE ELECTRIQUE**
VORRICHTUNG ZUR UNTERSTÜTZUNG EINER ENERGIESPEICHERANORDNUNG
DEVICE FOR SUPPORTING A POWER STORAGE ASSEMBLY

(30) Priorité: 30.04.2012 FR 1253982
(43) Date de publication de la demande: 11.03.2015
(73) Titulaire: Blue Solutions, 29500 Ergué Gabéric (FR)
(72) Inventeur: JUVENTIN, Anne-Claire, F-29000 Quimper (FR); LE GALL, Laurent, F-29500 Ergue Gaberic (FR)
(74) Mandataire: Regimbeau
(86) Numéro de dépôt international: PCT/EP2013/058967
(87) Numéro de publication internationale: WO 2013/164332

(56) Documents cités:
- EP-A1- 1 780 825
- EP-A1- 1 843 361
- EP-A2- 2 099 085
- WO-A1-2012/013641
- US-A- 989 738
- US-B1- 6 333 091

## Description

### DOMAINE TECHNIQUE

La présente invention concerne le domaine technique général des ensembles de stockage d'énergie électrique, notamment des modules comprenant une pluralité d'ensembles de stockage d'énergie disposés côté à côte et reliés électriquement.

On entend, dans le cadre de la présente invention, par « ensemble de stockage d'énergie électrique », soit un condensateur (i.e. un système passif comprenant deux électrodes et un isolant), soit un supercondensateur (i.e. un système comprenant au moins deux électrodes, un électrolyte et au moins un séparateur), soit une batterie de type batterie au lithium (i.e. un système comprenant au moins une anode, au moins une cathode et une solution d'électrolyte entre l'anode et la cathode).

### PRESENTATION GENERALE DE L'ART ANTERIEUR

Un ensemble de stockage d'énergie comprend généralement une enveloppe tubulaire fermée à au moins une de ses extrémités par un couvercle et dans lequel est placé un enroulement capacitif et un électrolyte liquide.

On connaît déjà dans l'état de la technique des modules de stockage d'énergie électrique comprenant un boîtier dans lequel sont disposés plusieurs ensembles de stockage d'énergie électrique 20 reliés deux à deux par des barrettes de liaison.

Ces modules comprennent généralement une carte électronique de gestion 40 pour la gestion de la charge et de la décharge des ensembles de stockage d'énergie électrique, afin d'équilibrer les caractéristiques électriques des ensembles.

Pour ce faire, la carte électronique est connectée électriquement à chaque ensemble de stockage d'énergie électrique en utilisant un câble électriquement conducteur respectif.

Le principe d'assemblage d'un tel module est le suivant. Les ensembles de stockage sont positionnés les uns à côté des autres. Les ensembles de stockage sont connectés électriquement deux à deux en soudant les barrettes de liaison sur les couvercles des ensembles de stockage. Une fois toutes les barrettes de liaison soudées sur les ensembles, on positionne les câbles de connexion permettant de relier chaque ensemble de stockage à la carte électronique.

Comme un module peut comprendre un nombre important d'ensembles de stockage (jusqu'à une centaine), on comprend qu'il est très complexe de positionner les câbles à l'intérieur du module, et l'assemblage du module nécessite un temps très long.

EP1780825 concerne un dispositif de maintien en position de cellules comprenant une plaque en matériau isolant et des supports isolant pour recevoir des moyens de connexion.

US6333091 concerne un dispositif de maintien en position de cellules comprenant une plaque en matériau isolant avec des ouvertures traversantes pour loger les cellules.

Un but de la présente invention est de proposer un dispositif et un procédé permettant de faciliter l'opération d'assemblage d'un module de stockage d'énergie électrique.

### PRESENTATION DE L'INVENTION

A cet effet, l'invention propose un dispositif selon la revendication 1 de maintien en position d'ensembles de stockage d'énergie disposés côte à côte dans un module de stockage d'énergie, le dispositif comprenant :
- une plaque réalisée en un matériau isolant électriquement et s'étendant selon un plan principal,
- des logements ménagés dans la plaque, chaque logement étant destiné à recevoir un ensemble de stockage d'énergie respectif de sorte que l'axe longitudinal de l'ensemble de stockage s'étende essentiellement perpendiculairement au plan principal,
- au moins un support en matériau isolant destiné à recevoir des moyens de connexion électrique pour connecter électriquement au moins un ensemble de stockage d'énergie à une carte électronique du module.

Le dispositif selon l'invention permet non seulement de faciliter le positionnement relatif des éléments et l'isolation des éléments les uns par rapport aux autres, mais il permet de réaliser l'intégration de tout ou partie de la connectique électrique directement sur la plaque et donc avant insertion des éléments. Cela facilite énormément l'assemblage. En outre, cela permet un gain de temps substantiel puisque les éléments de connectique peuvent être mis en place sur le dispositif en amont de la chaîne de montage principale, au vu de leur indépendance relativement à la présence ou non des ensembles dans le dispositif.

Des aspects préférés mais non limitatifs du module selon l'invention sont les suivants :
- le dispositif est conformé d'un seul tenant et comprend une unique plaque. Il n'est pas nécessaire de mettre en place un dispositif comportant deux plaques. On peut ainsi réduire les coûts liés au dispositif,
- le dispositif peut être apte à recevoir une pluralité de moyens de connexion distincts grâce à un seul ou plusieurs supports,
- le dispositif est réalisé en matière plastique, notamment par moulage, ce qui permet de disposer de peu de contraintes concernant la forme du dispositif et des différents éléments fonctionnels qu'il contient,
- le ou l'au moins un des supports comprend au moins une chambre s'étendant essentiellement perpendiculairement à la plaque, chaque chambre étant destinée à recevoir une fiche de connexion électrique respective. Cette fiche de connexion est notamment apte à coopérer avec un connecteur complémentaire relié électriquement à une borne d'un ensemble,
- chaque chambre peut être ouverte à une extrémité et comprend une attache pour la fixation de la fiche de connexion électrique, L'attache peut notamment s'étendre vers l'intérieur de la chambre essentiellement parallèlement au plan principal, l'attache comprenant une face inclinée en vis-à-vis de l'ouverture de la chambre pour faciliter l'insertion de la fiche de connexion dans la chambre et une face plane parallèle au plan principal pour bloquer la fiche de connexion une fois celle-ci insérée dans la chambre,
- le ou l'au moins un des supports comprend des moyens de guidage en matériau isolant électriquement s'étendant vers l'extérieur de la plaque pour guider le long d'un chemin de passage de câble ménagé sur le dispositif, au moins un câble de connexion apte à relier électriquement au moins un ensemble de stockage à la carte électronique. Ces moyens de guidage s'étendent notamment au moins en partie perpendiculairement à la plaque,
- les moyens de guidage comprennent préférentiellement deux doigts s'étendant perpendiculairement à la plaque et disposés de part et d'autre du chemin de passage de câble. Lesdits doigts sont décalés l'un par rapport à l'autre ou en regard l'un de l'autre le long du chemin de passage de câble, Chaque doigt comprend notamment une excroissance s'étendant parallèlement à la plaque en direction du chemin de passage de câble de sorte à permettre le clipsage et le maintien du câble entre lesdits doigts. Lorsque les deux doigts sont situés en regard, ils forment alors une pince élastique. Lorsque les doigts sont décalés, ils permettent de gérer le guidage du câble lorsque le chemin de passage du câble fait un virage,
- lorsque la chambre et les moyens de guidage d'un câble sont en combinaison dans le dispositif, ils peuvent être ménagés sur une même face ou sur deux faces opposées de la plaque,
- le ou l'au moins un des supports peut également être intégré à la plaque, les moyens de connexion électriques étant noyés dans l'ensemble constitué du support et de la plaque. Cela est notamment le cas lorsqu'il s'agit des câbles, On peut ainsi disposer la plaque au niveau de la partie centrale de l'ensemble de stockage, à distance des extrémités longitudinales de l'ensemble, afin de laisser libres les surfaces d'extrémité des ensembles qui sont déjà utilisées pour relier électriquement entre eux les ensembles et pour l'évacuation thermique du module. En configurant le dispositif de sorte qu'il puisse être placé en partie centrale des éléments, on simplifie la conception du dispositif puisque ce dernier n'a pas à prendre en compte les contraintes électriques et thermiques et on maximise les surfaces de contact entre les barrettes de connexion (placées généralement sur les faces extrêmes des éléments) et lesdits éléments, maximisant de fait la conduction thermique tout en minimisant la résistance entre les ensembles,
- chaque logement comprend notamment au moins une paroi de calage pour le calage et le centrage du dispositif sur les ensembles de stockage d'énergie, ladite paroi de calage étant positionnée au niveau de l'ouverture et s'étendant perpendiculairement à la plaque, en particulier de part et d'autre de celle-ci. On notera que la paroi de calage est disposée en bordure du logement et fait saillie de la plaque. L'extrémité d'une telle paroi de calage peut coopérer avec une extrémité d'une jupe périphérique d'un couvercle de l'ensemble de stockage, ce qui permet alors de positionner avec une meilleure précision les ensembles dans le dispositif,
- le dispositif comprend en outre au moins un fût s'étendant perpendiculairement à la plaque sur une de ses faces, ledit fût étant destiné à venir en contact avec une paroi du module de stockage d'énergie pour permettre le calage du dispositif dans le module de stockage d'énergie. Le fût peut également comprendre des moyens de fixation à la paroi du module, Il peut notamment comprendre une ouverture borgne taraudée s'étendant longitudinalement pour la fixation par vissage du dispositif contre une paroi du module,
- le dispositif comprend en outre un socle destiné à recevoir la carte électronique, et des moyens de fixation pour fixer la carte électronique sur ledit socle. Ces moyens comprennent par exemple un pion taraudé, la carte électronique étant fixée sur le socle par vissage. Le socle comprend par exemple un panneau s'étendant perpendiculairement à la plaque, au niveau de l'une des extrémités de celle-ci. Le panneau est notamment agencé relativement à la plaque de sorte qu'il s'étende de part et d'autre de la plaque,
- le dispositif comprend en outre des moyens d'accouplement situés à la périphérie de la plaque pour accrocher ledit dispositif à un autre dispositif de maintien selon l'une des revendications précédentes.
- le dispositif comprend en outre des moyens pour la fixation d'un capteur sur le dispositif, telle qu'une agrafe,
- le dispositif comprend en outre au moins une paroi essentiellement perpendiculaire à la plaque et à la périphérie de la plaque pour isoler électriquement les ensembles de stockage d'énergie des parois du module de stockage d'énergie. De préférence, il comprend une telle paroi sur chacun de ses côtés. Au moins une, de préférence chaque paroi s'étend de préférence sur toute la dimension du côté correspondant de la plaque et sur une hauteur supérieure ou égale à celle des ensembles. L'ensemble de ces parois peut notamment former un coffrage. On notera que chacune de ces parois est notamment agencée relativement à la plaque de sorte qu'elle s'étend de part et d'autre de la plaque,
- le dispositif comprend en outre des moyens s'étendant essentiellement perpendiculairement au plan principal pour le guidage d'un ou plusieurs renforts destinés à relier deux parois opposées du module. Ces moyens comprennent notamment des fûts s'étendant entre les logements et de hauteur sensiblement égale à la hauteur du module,
- le dispositif intègre préférentiellement :
   o Au moins une carte électronique, notamment sur le socle tel que décrit plus haut, et/ou
   o Au moins une fiche de connexion électrique à une borne d'un ensemble, notamment placée dans une chambre du dispositif telle que décrite plus haut, et/ou
   o Au moins une fiche de connexion à la carte électronique, et/ou
   o Au moins un câble de connexion pour relier la borne de l'ensemble à la carte électronique, notamment dans le chemin de passage de câble défini par les moyens de guidage tels que définis plus haut,
   o Au moins un capteur, notamment fixé à l'aide des moyens de fixation tels que définis plus haut,

L'invention concerne également un module de stockage d'énergie comprenant un boîtier dans lequel sont disposés au moins deux ensembles de stockage d'énergie électrique et comprenant un dispositif de maintien en position selon l'invention.

La plaque du dispositif comprend une ouverture traversante et est disposée de sorte que les ensembles fassent saillie de la plaque de part et d'autre de celle-ci. Autrement dit, la plaque s'étend en partie centrale des ensembles de stockage, à savoir que la distance entre la plaque et chacune des extrémités longitudinales de l'ensemble est supérieure à 20% de la distance entre lesdites deux extrémités longitudinales. Comme expliqué plus haut, il est très avantageux que la plaque soit en contact avec l'ensemble à distance des extrémités des ensembles, qui sont des zones fonctionnelles.

Chaque ensemble comprend un corps comprenant une paroi latérale et ouvert à au moins une de ses extrémités et au moins un couvercle fermant le corps à son extrémité ouverte. Chaque couvercle comprend une face d'extrémité et une jupe recouvrant la paroi latérale sur une portion de sa dimension longitudinale. La plaque est disposée relativement aux ensembles de façon être en contact avec la paroi latérale dans sa ou ses zones où elle n'est pas recouverte par la jupe de l'un des couvercles.

Le dispositif peut comprendre également une paroi de calage disposée au niveau de l'ouverture et s'étendant perpendiculairement à la plaque, l'extrémité de la paroi de calage coopérant avec l'extrémité de la jupe du ou de l'un des couvercles de l'ensemble, notamment par le biais d'un appui essentiellement linéaire situé dans un plan essentiellement parallèle de celui de la plaque. On peut ainsi facilement maintenir la plaque en partie centrale des ensembles sans que celle-ci ne se déplace relativement aux ensembles. On notera que les logements et/ou les parois de calage sont dimensionnés de sorte qu'ils sont de dimensions supérieures à celle de la paroi latérale de l'ensemble mais inférieures à celles de la jupe du couvercle.

De préférence, les ou au moins deux ensembles adjacents sont connectés électriquement à l'aide d'une barrette de liaison disposée sur deux faces d'extrémités des ensembles et s'étendant essentiellement parallèlement à la plaque lorsque les ensembles sont placés dans le dispositif de maintien, dans lequel le dispositif comprend une fiche de connexion agencée dans une chambre telle que définie aux revendications 2 et 3, ladite fiche de connexion étant apte à coopérer avec une languette située en saillie de la barrette de liaison, essentiellement perpendiculairement à la barrette.

L'invention concerne également un procédé de fabrication d'un module selon l'invention, le procédé comprenant les étapes suivantes :
- Insertion de chaque ensemble de stockage dans un logement respectif d'un dispositif de maintien, de préférence de sorte que les ensembles fassent saillie de la plaque de part et d'autre de celle-ci,
- Connexion électrique d'une barrette de liaison destinée à relier électriquement deux ensembles de stockage adjacents à des moyens de connexion positionnés au niveau du dispositif de maintien, pour relier électriquement la barrette de liaison à une carte électronique du module
- Soudage de la barrette de liaison aux deux ensembles de stockage adjacents pour relier électriquement lesdits ensembles de stockage adjacents.

Avantageusement, le procédé comprend en outre une étape consistant à positionner les moyens de connexion sur le dispositif de maintien, notamment avant l'étape d'insertion, ladite étape de positionnement comprenant :
- la mise en place d'un câble de connexion sur une plaque du dispositif à l'aide de moyens de guidage s'étendant perpendiculairement à la plaque,
- la mise en place d'une fiche de connexion dans une chambre du dispositif,
- la connexion électrique du câble de connexion à la fiche de connexion.

On notera qu'on peut insérer une partie des ensembles, notamment la moitié, de sorte que le couvercle de ces ensembles soit situé d'un premier côté de la plaque, puis retourner la plaque et insérer l'autre partie, notamment l'autre moitié, des ensembles, de sorte que leur couvercle soit situé de l'autre côté de la plaque.

### PRESENTATION DES FIGURES

D'autres caractéristiques, buts et avantages de la présente invention ressortiront encore de la description qui suit, laquelle est purement illustrative et non limitative et doit être lue en regard des dessins annexés sur lesquels :
- la figure 1 illustre schématiquement et en perspective un mode de réalisation d'un dispositif de maintien d'ensemble de stockage d'énergie électrique,
- la figure 2 illustre schématiquement et en perspective un autre mode de réalisation d'un dispositif de maintien d'ensemble de stockage d'énergie électrique,
- la figure 3 illustre schématiquement en coupe et en perspective une chambre du dispositif de maintien,
- la figure 4 illustre schématiquement deux ensembles de stockage d'énergie adjacents, reliés à l'aide d'une barrette de liaison,
- la figure 5 illustre schématiquement une pluralité d'ensembles de stockage d'énergie montés sur le dispositif de maintien,
- la figure 6 illustre schématiquement un détail du dispositif de maintien, montrant des moyens de guidage d'un câble,
- la figure 7 illustre schématiquement un détail du dispositif de maintien, montrant une agrafe du dispositif de maintien, pour la fixation d'un capteur sur celui-ci,
- la figure 8 illustre une pince du dispositif de maintien pour le guidage d'un câble,
- la figure 9 illustre un socle du dispositif de maintien,
- la figure 10 illustre des étapes d'un procédé de fabrication d'un module.

### DESCRIPTION DE L'INVENTION

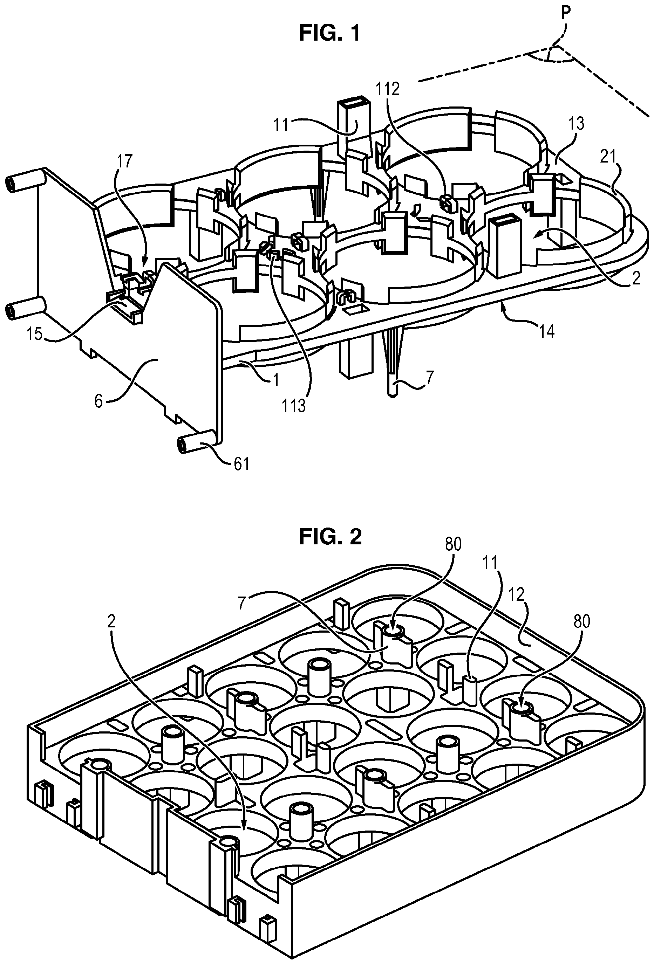

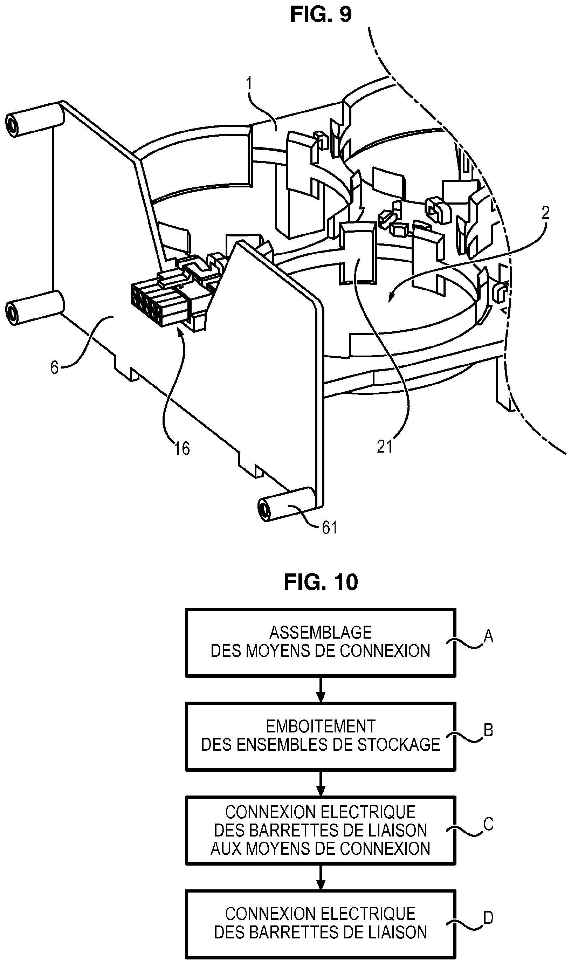

On va maintenant décrire différents modes de réalisation du dispositif de maintien en référence aux figures 1 à 9, ainsi qu'un exemple de procédé de fabrication d'un ensemble de stockage en référence à la figure 10. Dans ces différentes figures, les éléments équivalents du dispositif de maintien portent les mêmes références numériques.

### 1. Dispositif de maintien

En référence à la figure 1, le dispositif de maintien comprend une plaque 1, six logements et un support.

La plaque s'étend sensiblement dans un plan principal (P). Cette plaque est réalisée dans un matériau isolant électriquement tel que du plastique.

Les logements 2 sont ménagés dans la plaque 1. Chaque logement 2 est destiné à recevoir un (ou plusieurs) ensemble(s) de stockage d'énergie 3. Lorsque les ensembles de stockage 3 sont insérés dans les logements, les axes longitudinaux des ensembles de stockage s'étendent perpendiculairement au plan principal P.

Le support est destiné à recevoir les moyens de connexion, et notamment les câbles de connexion permettant de relier une carte électronique (non représentée) d'un module aux ensembles de stockage d'énergie.

La présence du support permet de faciliter le positionnement des moyens de connexion des ensembles à une carte électronique servant à la gestion et l'équilibrage des caractéristiques électriques des ensembles de stockage, notamment en définissant des chemins de passage pour les câbles de connexion s'étendant entre la carte électronique et les différents ensembles de stockage.

### 1.1. Support

Le support est réalisé dans un matériau isolant tel que du plastique. De préférence, le support et la plaque sont monobloc et obtenus par moulage.

Le support peut comprendre - séparément ou en combinaison - une (ou plusieurs) chambre(s) 11 ou logement 15 pour accueillir des fiches de connexion, ainsi que des moyens de guidage des câbles tels que des patte(s) de maintien 112 et/ou un (ou plusieurs) guide(s)113.

### 1.1.1. Moyens pour recevoir les fiches de connexion.

### 1.1.1.1. Chambre (fiche de connexion à une borne de l'ensemble)

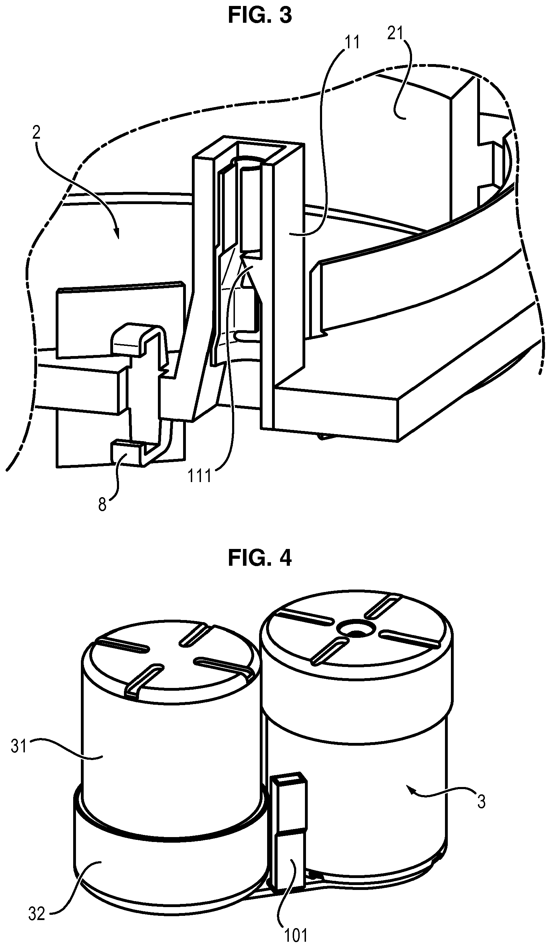

Comme illustré aux figures 1, 3, 4 et 5, chaque chambre 11 est destinée à recevoir une fiche de connexion électrique 4 respective, comme par exemple une fiche de connexion femelle - telle qu'une cosse Faston - pour l'insertion d'une connectique mâle complémentaire 101 électriquement reliée à un ensemble de stockage d'énergie électrique 3. Une telle connectique mâle complémentaire est agencée sur une barrette de liaison reliant deux ensembles de stockage. Comme on le voit mieux sur la figure 4, la barrette relie les deux ensembles en étant mis en place sur leur faces d'extrémités (ici, face inférieure), essentiellement parallèlement au plan P. Le connecteur mâle 101 est constitué par une languette s'étendant perpendiculairement au plan de la barrette.

La présence de chambres contenant une fiche de connexion permet de définir les zones de connexion des ensembles de stockage préalablement au montage du module et plus précisément préalablement à l'insertion des ensembles de stockage dans les logements du dispositif de maintien.

Ainsi, il est possible de positionner des câbles de connexion 5 reliant la carte électronique à chaque fiche de connexion préalablement à l'insertion des ensembles de stockage dans les logements 2.

Ceci permet de réduire le temps nécessaire à l'assemblage d'un module de stockage d'énergie électrique.

Dans le mode de réalisation illustré à la figure 1, le support comprend six chambres destinées à recevoir chacune une fiche de connexion respective pour la connexion électrique de six ensembles de stockage à la carte électronique.

Chaque chambre 11 s'étend vers l'extérieur de la plaque 1, perpendiculairement au plan principal P.

Chaque chambre 11 est composée de quatre parois formant une cheminée rectangulaire dans laquelle est insérée une fiche de connexion respective. Chaque chambre comprend une extrémité liée à la plaque et une extrémité libre opposée. La chambre est ouverte à chacune de ces extrémités.

Avantageusement, chaque chambre peut comprendre une attache 111 sur une de ses parois internes. Cette attache 111 fait saillie vers l'intérieur de la cheminée, parallèlement au plan principal P de la plaque. Elle permet de fixer la fiche de connexion dans la chambre.

L'attache 111 peut présenter un bord d'attaque incliné par rapport à la paroi sur laquelle elle fait saillie, en vis-à-vis de l'extrémité libre de la chambre, par laquelle est insérée la fiche 101 dans la chambre 11. Ceci permet de faciliter l'insertion de la fiche dans la chambre.

De préférence, la paroi de l'attache opposée à la paroi inclinée s'étend perpendiculairement à la paroi sur laquelle l'attache 111 fait saillie. Ceci permet d'assurer un meilleur blocage en position de la fiche de connexion une fois celle-ci insérée dans la chambre 11.

### 1.1.1.2. Logement (fiche de connexion à la carte électronique).

Comme on le voit sur les figures 1 et 9 en particulier, le dispositif de maintien comprend également un logement 15 pour loger une fiche de connexion 16 à une carte électronique apte à coopérer avec des broches adaptées de la carte électronique.

Un tel logement 15 est présent sur un panneau 61 perpendiculaire à la plaque 1 situé à la périphérie de la plaque. Le logement 15 comprend des rebords pour maintenir le connecteur. Un dégagement 17 peut également être ménagé au voisinage de celui-ci pour faciliter l'insertion de la fiche de connexion. Ici, le dégagement se resserre en direction du logement 15 pour guider la fiche de connexion et être adapté au cas d'un procédé automatisé.

### 1.1.2. Moyens de guidage des câbles

Les moyens de guidage sont destinés à maintenir un ou plusieurs des câbles de connexion 5 reliant électriquement la carte électronique aux ensembles de stockage d'énergie électrique 3. On va décrire ci-dessous les deux types de moyens de guidage représentés sur les figures.

### 1.1.2.1. Pattes

Chaque patte 112 s'étend sur une paroi de la plaque, perpendiculairement au plan principal P.

En référence à la figure 1, une patte est associée à chaque chambre, au voisinage de l'extrémité liée de la chambre 11, par laquelle les câbles transitent jusqu'à la fiche de connexion 111. Chaque chambre et sa patte associée s'étendent sur des faces opposées de la plaque. Le dispositif comprend également d'autres pattes le long de la plaque non associées à une chambre. Cet ensemble de pattes permet d'assurer un bon placage des câbles de connexion contre la plaque.

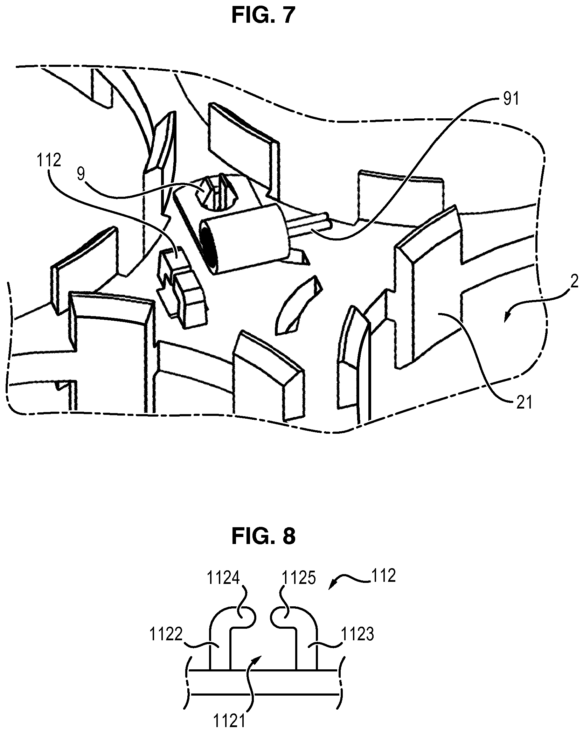

Comme illustré à la figure 8, chaque patte comprend une fente 1121 s'étendant sur toute la hauteur de la patte. Cette fente est destinée à recevoir le ou les câbles de connexion et définit ainsi le chemin de passage des câbles. Cette fente définit une pince élastique composée de deux branches (ou doigts) 1122, 1123 en regard, l'extrémité libre de chaque branche comprenant un ergot (ou excroissance) 1124, 1125 s'étendant vers la branche 1123, 1122 en regard. Ceci permet le clipsage et le maintien en position de chaque câble de connexion 5 contre la plaque 1.

Dans le mode de réalisation illustré à la figure 1, des chambres 11 sont agencées sur les deux faces opposées de la plaque 1. De même des pattes 112 sont prévues de part et d'autre de la plaque 1. Ceci permet de doubler le nombre de chemins de passage possibles pour les câbles de connexion 5 et donc d'optimiser l'ergonomie du module.

### 1.1.2.2. Guide

Chaque guide 113 permet le guidage d'un ou plusieurs câbles de connexion 5. Plus précisément, chaque guide 113 permet de changer la direction dans laquelle s'étend le câble de connexion 5 positionné en son sein.

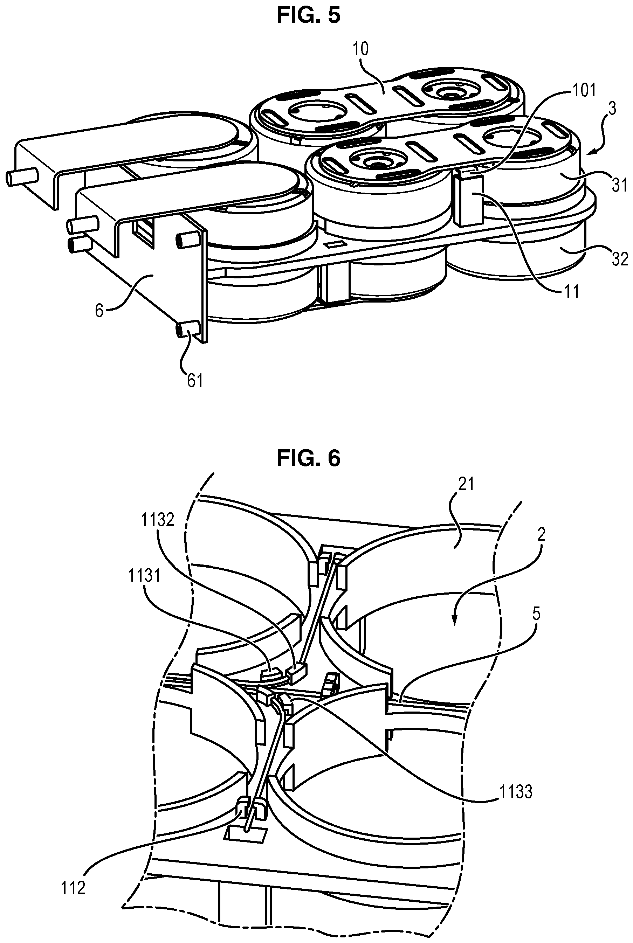

En référence à la figure 6, chaque guide 113 fait saillie vers l'extérieur de la plaque perpendiculairement au plan principal P. Chaque guide 113 est composé de deux doigts 1131, 1132 disposés de part et d'autre d'un chemin de passage de câble de connexion. Plus précisément, une fois un câble de connexion installé dans le guide 113, celui-ci s'étend entre les doigts 1131, 1132.

Dans le mode de réalisation illustré à la figure 6, les doigts comprennent chacun une excroissance respective s'étendant parallèlement à la plaque en direction du chemin de passage. Ceci permet d'assurer un bon maintien du (ou des) câble(s) de connexion contre la plaque.

De préférence, les doigts 1131, 1132 sont décalés l'un par rapport à l'autre le long du chemin de passage. Ceci permet de faciliter le changement d'orientation du câble de connexion tout en assurant un bon placage du câble de connexion contre la plaque au niveau de ce changement d'orientation. Les doigts peuvent dans ce cas être curvilignes (ce qui signifie que leur intersection avec la plaque est curviligne).

### 1.2. Logement

Le logement 2 peut être prévu pour recevoir :
- deux ensembles de stockage d'énergie 3 et une barrette liaison 10, ou
- un unique ensemble de stockage 3, comme cela est le cas sur les modes de réalisation représentés.

Chaque logement 2 consiste en une ouverture traversante destinée à recevoir un ensemble de stockage d'énergie respectif, comme illustré à la figure 1. On notera qu'on dispose le dispositif de sorte que la plaque soit située en partie centrale des ensembles, les ensembles faisant saillie de la plaque de part et d'autre de celle-ci. La plaque est donc placée à distance des zones fonctionnelles que constituent les faces extrêmes de l'ensemble selon la direction longitudinale de celui-ci.

Cela permet de faciliter le positionnement des ensembles de stockage d'énergie les uns par rapport aux autres en vue du soudage des barrettes de liaison sur ceux-ci. Par ailleurs, cela facilite l'opération d'assemblage du module. En effet, lorsque la connectique destinée à être connectée à la fiche de connexion est placée sur la barrette, comme cela est représenté sur les figures, il est plus facile d'ajuster chaque barrette relativement à sa fiche de connexion associée plutôt que d'ajuster les fiches de connexion par rapport aux barrettes déjà soudées et dont les positions relatives peuvent varier.

La forme et les dimensions de l'ouverture traversante correspondent à la forme et aux dimensions de la section transversale d'une face latérale 31 de l'ensemble de stockage d'énergie électrique 3, dans une portion dans laquelle elle n'est pas recouverte par la jupe 32 du couvercle.

Ceci permet un emboîtement - éventuellement en force - de chaque ensemble de stockage d'énergie 3 dans une ouverture respective.

Avantageusement, chaque logement 2 peut comprendre une (ou plusieurs) paroi(s) positionnée(s) au niveau de l'ouverture et s'étendant perpendiculairement à la plaque, de part et d'autre de celle-ci.

Ceci permet d'assurer le calage et le centrage du dispositif sur les ensembles de stockage d'énergie. La forme de cette paroi - dite paroi de calage - suivant au moins partiellement le contour de la face latérale 31 de l'ensemble de stockage d'énergie électrique.

De préférence, une extrémité de cette surface est destinée à être en appui contre une extrémité d'un bord tombé (ou jupe) d'un couvercle 32 de l'ensemble, entourant le corps de celui-ci, comme illustré à la figure 5. Ceci permet d'éviter un glissement des ensembles de stockage d'énergie électrique par rapport au dispositif de maintien, et ce quelle que soit l'orientation du module, celui-ci n'étant pas forcément orienté de sorte que les axes longitudinaux des ensembles de stockage soient verticaux.

### 1.3. Autres éléments du dispositif

### 1.3.1. Fût

En variante ou en complément de la paroi de calage, le dispositif peut comprendre un (ou plusieurs) fût(s) 7 s'étendant perpendiculairement à la plaque sur une de ses faces (ou sur ses deux faces).

La longueur du fût est prévue suffisante pour que l'extrémité libre du fût vienne en contact avec un fond du module de stockage d'énergie afin d'assurer le calage du dispositif dans le module de stockage d'énergie.

Chaque fût 7 peut comprendre une ouverture borgne taraudée s'étendant le long de l'axe longitudinal du fût 7. Cette ouverture taraudée est destinée à accueillir un moyen de serrage pour fixer le dispositif sur une paroi du module.

### 1.3.2. Socle

Le dispositif peut également comprendre un socle destiné à recevoir une (ou plusieurs) carte(s) électronique(s). Ce socle 6 est par exemple positionné à la périphérie de la plaque 1.

Dans le mode de réalisation illustré à la figure 1, le socle est composé :
- d'un panneau 6 s'étendant perpendiculairement à la plaque à l'une des extrémités de celle-ci,
- des moyens de fixation constitués de quatre pions 61 incluant chacun un évidement pour l'insertion d'un moyen de fixation de la carte électronique sur les pions.

Dans les modes de réalisation représentés, on notera que c'est dans ce socle qu'est ménagé le logement 15 qui accueille la fiche de connexion 16 reliant les câbles à la carte électronique.

### 1.3.3. Agrafe

Le module peut comprendre un capteur - tel qu'un capteur de température - pour la mesure de caractéristiques du module.

Pour permettre la fixation d'un tel capteur, le dispositif de maintien peut inclure une agrafe telle qu'une agrafe élastique, ménagée en saillie de la plaque et permettant de fixer le capteur par clipsage.

### 1.3.4. Coffrage

Le dispositif de maintien peut également comprendre des moyens d'isolation des ensembles de stockage d'énergie relativement à au moins une paroi du boîtier.

De préférence, ces moyens d'isolation sont constitués par au moins une paroi de la pièce longeant la paroi du boîtier et présentant de préférence les mêmes dimensions que celle-ci.

Cela permet d'éviter l'insertion également complexe entre les parois du boîtier et le dispositif de maintien d'une garniture d'isolation telle qu'une mousse. Une telle paroi est de préférence perpendiculaire au plan dans lequel s'étendent les logements.

Dans le mode de réalisation illustré à la figure 2, la structure comprend un coffrage 12 composé de quatre parois s'étendant à la périphérie de la plaque perpendiculairement au plan P de sorte à entourer les ensembles de stockage d'énergie électrique.

### 1.3.5. Moyens de guidage de moyens de renfort.

Le dispositif peut également comprendre, comme on le voit à la figure 2, des fûts 80 s'étendant sur toute la hauteur du module une fois ce dernier assemblé. Ces fûts comprennent une ouverture traversante et permettent d'accueillir des moyens de renfort du module, reliant notamment la paroi supérieure et la paroi inférieure du module, pour renforcer mécaniquement ce dernier. De tels fûts sont situés entre les logements. Ils permettent d'assurer le bon positionnement des moyens de renfort (pas de fluage) et leur isolation des ensembles de stockage (de tels renforts sont souvent réalisés en métal, conducteur).

### 2. Procédé de fabrication

Ainsi, l'invention utilise un dispositif de maintien comprenant des moyens adaptés pour l'intégration de nombreuses fonctions, ce qui permet de gagner un temps précieux d'assemblage du module. De ce fait, même si la pièce constituant le dispositif de maintien est une pièce supplémentaire qui a un coût, elle permet d'éviter l'utilisation de nombreux autres éléments de construction et simplifie le procédé de fabrication. Les coûts du module sont donc diminués.

On va maintenant décrire un exemple de procédé de fabrication de module en référence à la figure 10.

Dans une étape du procédé (étape A), on assemble les moyens de connexion électrique (i.e. fiche de connexion, câble de connexion, etc.) sur le dispositif de maintien, préalablement à l'introduction des ensembles de stockage dans les logements.

Cette étape de positionnement des moyens de connexion sur le dispositif de maintien comprend les sous-étapes consistant à :
- mettre en place les câbles de connexion sur une plaque du dispositif en fixant les câbles aux guides et aux pattes de sorte à plaquer les câbles contre la paroi de la plaque,
- mettre en place les fiches de connexion aux ensembles de stockage dans les chambres,
- mettre en place les fiches de connexion à la carte électronique dans le logement 15
- connecter électriquement les câbles de connexion aux fiches de connexion.

Une fois les moyens de connexion préparés sur le dispositif, le procédé comprend les étapes suivantes :
- Insertion (étape B) de chaque ensemble de stockage dans un logement respectif d'un dispositif de maintien. Lors de cette étape, on insère notamment trois des ensembles dans les ouvertures traversantes par un premier côté de la plaque, jusqu'à ce que l'extrémité de la jupe 32 du couvercle vienne en butée contre les parois de calage, puis on retourne le dispositif et on insère les trois autres ensembles par l'autre côté de la plaque jusqu'à ce que les extrémités de la jupe du couvercle de chaque ensemble vienne en butée contre la paroi de calage correspondante,
- Connexion électrique (étape C) des barrettes de liaison destinées à relier électriquement deux ensembles de stockage adjacents aux moyens de connexion positionnés au niveau du dispositif de maintien. Soudage (étape D) de barrette de liaison sur les deux ensembles de stockages adjacents pour relier électriquement lesdits ensembles de stockage adjacents.

Les étapes C et D sont plus particulièrement effectuées d'un côté du module pour relier entre elles les extrémités des ensembles situées à une première extrémité du module puis on retourne le module et on effectue les étapes C et D pour relier entre elles les extrémités des ensembles situées à l'autre extrémité du module.

La structure ainsi obtenue est ensuite disposée dans un boîtier du module et refermé.

### 3. Alternatives

Le lecteur aura compris que de nombreuses modifications peuvent être apportées au dispositif décrit précédemment sans sortir matériellement des nouveaux enseignements et des avantages décrits ici.

Par exemple, le support peut être intégré à la plaque, les moyens de connexion étant noyés dans l'ensemble constitué du support et de la plaque. Dans ce cas, le support ne comprend ni patte, ni guide, mais peut comprendre des chambre destinées à recevoir chacune une fiche de connexion électrique.

Le dispositif peut également être modulaire, c'est-à-dire constituer une portion d'un ensemble comprenant une pluralité de dispositifs connectés les uns aux autres. Ceci permet de former des modules présentant des nombres d'ensembles de stockage variables à partir d'un unique type de dispositif. Dans ce cas, le dispositif peut par exemple comprendre à la périphérie de la plaque, un moyen d'accouplement 8 permettant d'accrocher ensemble deux dispositifs de maintien selon l'invention.

## Revendications

1. Dispositif de maintien en position d'ensembles de stockage d'énergie (3) disposés côte à côte dans un module de stockage d'énergie, le dispositif comprenant :
- une plaque (1) réalisée en un matériau isolant électriquement et s'étendant selon un plan principal (P),
- des logements (2) ménagés dans la plaque, chaque logement étant destiné à recevoir un ensemble de stockage d'énergie respectif de sorte que l'axe longitudinal de l'ensemble de stockage s'étende essentiellement perpendiculairement au plan principal (P),
au moins un support (11, 112, 113) en matériau isolant destiné à recevoir des moyens de connexion électrique entre au moins un ensemble de stockage d'énergie (3) et une carte électronique du module, ledit support (11, 112, 113) et ladite plaque (1) étant monobloc,
ce dispositif étant **caractérisé en ce que** chaque logement consiste en une ouverture traversante ménagée dans ladite plaque (1), la forme de l'ouverture traversante correspondant à la forme en section transversale d'une face latérale (31) de l'ensemble de stockage d'énergie électrique, les dimensions de l'ouverture étant prévues pour permettre un emboîtement de l'ensemble de stockage d'énergie dans ladite ouverture de sorte que l'ensemble de stockage d'énergie s'étende de part et d'autre de l'ouverture.

2. Dispositif selon la revendication 1, **caractérisé en ce que** le ou l'au moins un des supports comprend au moins une chambre (11) s'étendant essentiellement perpendiculairement à la plaque, chaque chambre étant destinée à recevoir une fiche de connexion électrique (4) respective.

3. Dispositif selon la revendication 2, **caractérisé en ce que** chaque chambre est ouverte à une extrémité et comprend une attache (111) pour la fixation de la fiche de connexion électrique.

4. Dispositif selon l'une quelconque des revendications précédentes, **caractérisé en ce que** le ou l'au moins un des supports comprend des moyens de guidage (112, 113) en matériau isolant électriquement s'étendant vers l'extérieur de la plaque pour guider le long d'un chemin de passage de câble ménagé sur le dispositif au moins un câble de connexion (5) apte à relier électriquement au moins un ensemble de stockage à la carte électronique.

5. Dispositif selon la revendication précédente, **caractérisé en ce que** les moyens de guidage comprennent deux doigts (1122, 1123 ; 1131, 1132) s'étendant perpendiculairement à la plaque et disposés de part et d'autre du chemin de passage de câble.

6. Dispositif selon la revendication précédente, **caractérisé en ce que** chaque doigt comprend une excroissance (1124 ; 1225 ; 1133) s'étendant parallèlement à la plaque en direction du chemin de passage de câble de sorte à permettre le clipsage et le maintien du câble entre lesdits doigts.

7. Dispositif selon l'une quelconque des revendications précédentes, **caractérisé en ce que** le ou l'au moins un des supports est intégré à la plaque, les moyens de connexion électriques étant noyés dans l'ensemble constitué du support et de la plaque.

8. Dispositif selon la revendication précédente, **caractérisé en ce que** chaque logement comprend en outre au moins une paroi de calage (21) pour le calage et le centrage du dispositif sur les ensembles de stockage d'énergie, ladite paroi de calage étant positionnée au niveau de l'ouverture et s'étendant perpendiculairement à la plaque.

9. Dispositif selon l'une quelconque des revendications précédentes, **caractérisé en ce qu'**il comprend en outre au moins un fût (7) s'étendant perpendiculairement à la plaque sur une de ses faces, ledit fût étant destiné à venir en contact avec une paroi du module de stockage d'énergie pour permettre le calage du dispositif dans le module de stockage d'énergie.

10. Dispositif selon l'une quelconque des revendications précédentes, **caractérisé en ce qu'**il comprend en outre un socle (6) destiné à recevoir la carte électronique, et des moyens de fixation (61) pour fixer la carte électronique sur ledit socle.

11. Dispositif selon l'une quelconque des revendications précédentes, **caractérisé en ce qu'**il comprend en outre des moyens d'accouplement (8) situés à la périphérie de la plaque pour accrocher ledit dispositif à un autre dispositif de maintien selon l'une des revendications précédentes.

12. Dispositif selon l'une quelconque des revendications précédentes, **caractérisé en ce qu'**il comprend en outre des moyens (9) pour la fixation d'un capteur (91) sur le dispositif.

13. Dispositif selon l'une quelconque des revendications précédentes, **caractérisé en ce qu'**il comprend en outre au moins une paroi essentiellement perpendiculaire à la plaque et à la périphérie de la plaque pour isoler électriquement les ensembles de stockage d'énergie des parois du module de stockage d'énergie.

14. Dispositif selon l'une quelconque des revendications précédentes, **caractérisé en ce qu'**il comprend des moyens de guidage (80) de moyens de renforts destinés à relier deux parois opposées du module, ces moyens de guidage (80), tels un fût muni d'une ouverture traversante, s'étendant essentiellement perpendiculairement au plan principal de ladite plaque (1).

15. Dispositif selon l'une quelconque des revendications précédentes, **caractérisé en ce qu'**il intègre :
o au moins une carte électronique, et/ou
o au moins une fiche de connexion électrique à une borne d'un ensemble, et/ou
o au moins une fiche de connexion à la carte électronique, et/ou
o au moins un câble de connexion pour relier la borne de l'ensemble à la carte électronique, et/ou
o au moins un capteur.

16. Module de stockage d'énergie comprenant un boîtier dans lequel sont disposés au moins deux ensembles de stockage d'énergie électrique, **caractérisé en ce que** le module comprend un dispositif de maintien en position selon l'une des revendications précédentes, chaque ensemble (3) étant disposé dans une ouverture respective et faisant saillie de la plaque (1) du dispositif de part et d'autre de celle-ci.

17. Module selon la revendication précédente, dans lequel les ou au moins deux ensembles adjacents sont connectés électriquement à l'aide d'une barrette de liaison disposée sur deux faces d'extrémités des ensembles et s'étendant essentiellement parallèlement à la plaque lorsque les ensembles sont placés dans le dispositif de maintien, **caractérisé en ce que** le dispositif comprend une fiche de connexion agencée dans une chambre telle que définie aux revendications 2 et 3, ladite fiche de connexion étant apte à coopérer avec une languette située en saillie de la barrette de liaison, essentiellement perpendiculairement à la barrette.

18. Procédé de fabrication d'un module selon la revendication 16 ou la revendication 17, **caractérisé en ce qu'**il comprend les étapes suivantes :
- insertion de chaque ensemble de stockage dans un logement respectif d'un dispositif de maintien, chaque ensemble (3) faisant saillie de la plaque (1) du dispositif de part et d'autre de celle-ci,
- connexion électrique d'une barrette de liaison destinée à relier électriquement deux ensembles de stockage adjacents à des moyens de connexion positionnés au niveau du dispositif de maintien, pour relier électriquement la barrette de liaison à une carte électronique du module,
- soudage de la barrette de liaison aux deux ensembles de stockage adjacents, pour relier électriquement lesdits ensembles de stockage adjacents.

19. Procédé de fabrication selon la revendication précédente, **caractérisé en ce qu'**il comprend en outre une étape consistant à positionner les moyens de connexion sur le dispositif de maintien, ladite étape de positionnement comprenant :
- la mise en place d'un câble de connexion sur une plaque du dispositif à l'aide de moyens de guidage s'étendant perpendiculairement à la plaque,
- la mise en place d'une fiche de connexion dans une chambre du dispositif,
- la connexion électrique du câble de connexion à la fiche de connexion.

## Patentansprüche

1. Vorrichtung zum Halten von Energiespeicheranordnungen (3), die nebeneinander in einem Energiespeichermodul angeordnet sind, an ihrer Position, wobei die Vorrichtung Folgendes umfasst:
- eine Platte (1), die aus einem elektrisch isolierendem Material hergestellt ist und sich entlang einer Hauptebene (P) erstreckt,
- Aufnahmen (2), die in der Platte eingerichtet sind, wobei jede Aufnahme dazu bestimmt ist, eine entsprechende Energiespeicheranordnung aufzunehmen, derart, dass die Längsachse der Speicheranordnung sich im Wesentlichen senkrecht zur Hauptebene (P) erstreckt,
- mindestens eine Unterstützung (11, 112, 113) aus isolierendem Material, die dazu bestimmt ist, Mittel zur elektrischen Verbindung zwischen mindestens einer Energiespeicheranordnung (3) und einer elektronischen Karte des Moduls aufzunehmen, wobei die Unterstützung (11, 112, 113) und die Platte (1) aus einem Stück sind,
wobei diese Vorrichtung **dadurch gekennzeichnet ist, dass** jede Aufnahme aus einer Durchgangsöffnung besteht, die in der Platte (1) eingerichtet ist, wobei die Form der Durchgangsöffnung der Querschnittsform einer Seitenfläche (31) der Anordnung zur Speicherung elektrischer Energie entspricht, wobei die Abmessungen der Öffnung vorgesehen sind, um ein Einpassen der Energiespeicheranordnung in der Öffnung zu ermöglichen, derart, dass die Energiespeicheranordnung sich auf beiden Seiten der Öffnung erstreckt.

2. Vorrichtung nach Anspruch 1, **dadurch gekennzeichnet, dass** die oder mindestens eine von den Unterstützungen mindestens eine Kammer (11) umfasst, die sich im Wesentlichen senkrecht zu der Platte erstreckt, wobei jede Kammer dazu bestimmt ist, einen entsprechenden elektrischen Verbindungsstecker (4) aufzunehmen.

3. Vorrichtung nach Anspruch 2, **dadurch gekennzeichnet, dass** jede Kammer an einem Ende offen ist und einen Verbinder (111) für die Befestigung des elektrischen Verbindungssteckers umfasst.

4. Vorrichtung nach einem der vorhergehenden Ansprüche, **dadurch gekennzeichnet, dass** die oder mindestens eine von den Unterstützungen Führungsmittel (112, 113) aus elektrisch isolierendem Material umfasst, die sich in Richtung der Außenseite der Platte erstrecken, um mindestens ein Verbindungskabel (5), das geeignet ist, mindestens eine Speicheranordnung elektrisch mit der elektronischen Karte zu verbinden, entlang eines Kabeldurchgangswegs, der auf der Vorrichtung eingerichtet ist, zu führen.

5. Vorrichtung nach dem vorhergehenden Anspruch, **dadurch gekennzeichnet, dass** die Führungsmittel zwei Finger (1122, 1123; 1131, 1132) umfassen, die sich senkrecht zu der Platte erstrecken und auf beiden Seiten des Kabeldurchgangswegs angeordnet sind.

6. Vorrichtung nach dem vorhergehenden Anspruch, **dadurch gekennzeichnet, dass** jeder Finger einen Vorsprung (1124; 1225; 1133) umfasst, der sich derart parallel zur Platte in Richtung des Kabeldurchgangswegs erstreckt, dass er das Clipsen und das Halten des Kabels zwischen den Fingern ermöglicht.

7. Vorrichtung nach einem der vorhergehenden Ansprüche, **dadurch gekennzeichnet, dass** die oder mindestens eine der Unterstützungen in die Platte integriert ist, wobei die elektrischen Verbindungsmittel in der Anordnung, die aus der Unterstützung und der Platte besteht, versenkt sind.

8. Vorrichtung nach dem vorhergehenden Anspruch, **dadurch gekennzeichnet, dass** jede Aufnahme ferner mindestens eine Verkeilungswand (21) für die Verkeilung und die Zentrierung der Vorrichtung auf den Energiespeicheranordnungen umfasst, wobei die Verkeilungswand im Bereich der Öffnung positioniert ist und sich senkrecht zur Platte erstreckt.

9. Vorrichtung nach einem der vorhergehenden Ansprüche, **dadurch gekennzeichnet, dass** sie mindestens einen Schaft (7) umfasst, der sich senkrecht zu der Platte auf einer ihrer Flächen erstreckt, wobei der Schaft dazu bestimmt ist, mit einer Wand des Energiespeichermoduls in Kontakt zu gelangen, um die Verkeilung der Vorrichtung in dem Energiespeichermodul zu ermöglichen.

10. Vorrichtung nach einem der vorhergehenden Ansprüche, **dadurch gekennzeichnet, dass** sie ferner einen Sockel (6), der dazu bestimmt ist, die elektronische Karte aufzunehmen, und Befestigungsmittel (61) zum Befestigen der elektronischen Karte auf dem Sockel umfasst.

11. Vorrichtung nach einem der vorhergehenden Ansprüche, **dadurch gekennzeichnet, dass** sie ferner Kopplungsmittel (8) umfasst, die sich am Umfang der Platte befinden, um die Vorrichtung an eine andere Haltevorrichtung nach einem der vorhergehenden Ansprüche anzuhängen.

12. Vorrichtung nach einem der vorhergehenden Ansprüche, **dadurch gekennzeichnet, dass** sie ferner Mittel (9) zur Befestigung eines Sensors (91) auf der Vorrichtung umfasst.

13. Vorrichtung nach einem der vorhergehenden Ansprüche, **dadurch gekennzeichnet, dass** sie ferner mindestens eine Wand umfasst, die im Wesentlichen senkrecht zur Platte und zum Umfang der Platte ist, um die Energiespeicheranordnungen elektrisch von den Wänden des Energiespeichermodus zu isolieren.

14. Vorrichtung nach einem der vorhergehenden Ansprüche, **dadurch gekennzeichnet, dass** sie Mittel (80) zur Führung von Verstärkungsmitteln umfasst, die dazu bestimmt sind, zwei gegenüberliegende Wände des Moduls zu verbinden, wobei diese Führungsmittel (80), wie ein Schaft, der mit einer Durchgangsöffnung versehen ist, sich im Wesentlichen senkrecht zur Hauptebene der Platte (1) erstrecken.

15. Vorrichtung nach einem der vorhergehenden Ansprüche, **dadurch gekennzeichnet, dass** sie Folgendes integriert:
∘ mindestens eine elektronische Karte und/oder
∘ mindestens einen Stecker zur elektrischen Verbindung mit einem Anschluss einer Anordnung und/oder
∘ mindestens einen Stecker zur Verbindung mit der elektronischen Karte und/oder
∘ mindestens ein Verbindungskabel zum Verbinden des Anschlusses der Anordnung mit der elektronischen Karte und/oder
∘ mindestens einen Sensor.

16. Energiespeichermodul, das ein Gehäuse umfasst, in dem mindestens zwei Anordnungen zur Speicherung elektrischer Energie angeordnet sind, **dadurch gekennzeichnet, dass** das Modul eine Vorrichtung zum Halten an der Position nach einem der vorhergehenden Ansprüche umfasst, wobei jede Anordnung (3) in einer entsprechenden Öffnung angeordnet ist und von der Platte (1) der Vorrichtung auf beiden Seiten davon hervorsteht.

17. Modul nach dem vorhergehenden Anspruch, wobei die oder mindestens zwei benachbarte Anordnungen mittels einer Verbindungsleiste elektrisch verbunden sind, die auf zwei Endflächen der Anordnungen angeordnet ist und sich im Wesentlichen parallel zur Platte erstreckt, wenn die Anordnungen in der Haltevorrichtung platziert sind, **dadurch gekennzeichnet, dass** die Vorrichtung einen Verbindungsstecker umfasst, der in einer Kammer nach einem der Ansprüche 2 und 3 angeordnet ist, wobei der Verbindungsstecker geeignet ist, mit einem Flachstecker zusammenzuwirken, der sich von der Verbindungsleiste im Wesentlichen senkrecht zur Verbindungsleiste hervorstehend befindet.

18. Verfahren zur Herstellung eines Moduls nach Anspruch 16 oder Anspruch 17, **dadurch gekennzeichnet, dass** es die folgenden Schritte umfasst:
- Einsetzen von jeder Speicheranordnung in eine entsprechende Aufnahme einer Haltevorrichtung, wobei jede Anordnung (3) von der Platte (1) der Vorrichtung auf beiden Seiten davon hervorsteht,
- elektrisches Verbinden einer Verbindungsleiste, die dazu bestimmt ist, zwei benachbarte Speicheranordnungen mit Verbindungsmitteln zu verbinden, die im Bereich der Haltevorrichtung positioniert sind, um die Verbindungsleiste elektrisch mit einer elektronischen Karte des Moduls zu verbinden,
- Schweißen der Verbindungsleiste an die zwei benachbarten Speichervorrichtungen, um die benachbarten Speichervorrichtungen elektrisch zu verbinden.

19. Herstellungsverfahren nach dem vorhergehenden Anspruch, **dadurch gekennzeichnet, dass** es ferner einen Schritt umfasst, der darin besteht, die Verbindungsmittel auf der Haltevorrichtung zu positionieren, wobei der Positionierungsschritt Folgendes umfasst:
- Einrichten eines Verbindungskabels auf einer Platte der Vorrichtung mittels Führungsmitteln, die sich senkrecht zur Platte erstrecken,
- Einrichten eines Verbindungssteckers in einer Kammer der Vorrichtung,
- elektrisches Verbinden des Verbindungskabels mit dem Verbindungsstecker.

## Claims

1. A device for supporting power storage assemblies (3) positioned side by side in a power storage module, the device including:
- a plate (1) made of an electrically insulating material and extending along a principal plane (P),
- recesses (2) formed in the plate, each recess being suitable for accommodating a respective power storage assembly, so that the longitudinal axis of the storage assembly extends essentially perpendicular to the principal plane (P),
- at least one support (11, 112, 113) made of electrically insulating material suitable for accommodating electrical connection means for electrically connecting at least one power storage assembly (3) to an electronic card of the module,
the support (11, 112, 113) and the plate (1) being a single unit, this device being **characterized in that** each recess consists of a through opening formed in the plate, the shape of the through opening corresponding to the cross-section shape of a lateral face (31) of the electrical power storage assembly, the dimensions of the opening being suitable for allowing nesting of the power storage assembly into said opening such that the power storage assembly extends to either side of the opening.

2. The device according to Claim 1, **characterized in that** the, or at least one of the supports includes at least one chamber (11) extending essentially perpendicular to the plate, each chamber being suitable for accommodating a respective electrical connection plug (4).

3. The device according to Claim 2, **characterized in that** each chamber is open at one end and includes a tie (111) for attaching the electrical connection plug.

4. The device according to any one of the preceding claims, **characterized in that** the, or at least one of the supports includes guide means (112, 113) made of electrically insulating material extending toward the outside of the plate for guiding along a passage channel a cable provided on the device, a least one connecting cable (5) capable of electrically connecting at least one storage assembly to the electronic card.

5. The device according to the preceding claim, **characterized in that** the guide means include two fingers (1122, 1123; 1131, 1132) extending perpendicular to the plate and positioned on either side of the cable passage channel.

6. The device according to the preceding claim, **characterized in that** each finger includes an excrescence (1124; 1225; 1133) extending parallel to the plate in the direction of the cable passage channel so as to allow clipping and support of the cable between said fingers.

7. The device according to any one of the preceding claims, **characterized in that** the, or at least one of the supports is integrated with the plate, the electrical connection means being embedded in the assembly consisting of the support and of the plate.

8. The device according to the preceding claim, **characterized in that** each recess also includes at least one shimming wall (21) for shimming and centering the device on the power storage assemblies, said shimming wall being positioned at the opening and extending perpendicular to the plate.

9. The device according to any one of the preceding claims, **characterized in that** it also includes at least one shank (7) extending perpendicular to the plate over one of its faces, said shank being suitable for coming into contact with a wall of the power storage module to allow shimming of the device within the power storage module.

10. The device according to any of the preceding claims, **characterized in that** it also includes a base (6) suitable for accommodating an electronic card and attachment means (61) for attaching the card to said base.

11. The device according to any one of the preceding claims, **characterized in that** it also includes coupling means (8) located at the edge of the plate for fastening said device to another supporting device according to one of the preceding claims.

12. The device according to any one of the preceding claims, **characterized in that** it also includes means (9) for attaching a sensor (91) on the device.

13. The device according to any one of the preceding claims, **characterized in that** it also includes at least one wall essentially perpendicular to the plate and at the edge of the plate to electrically isolate the power storage assemblies from the walls of the power storage module.

14. The device according to any one of the preceding claims, **characterized in that** it includes guiding means (80) for guiding reinforcements intended to link two opposite walls of the module, these guiding means (80), such as a barrel provided with a through opening, extending essentially perpendicular to the principal plane, of said plate (1).

15. The device according to any one of the preceding claims, **characterized in that** it integrates:
∘ at least one electronic card, and/or
∘ at least one electrical connection plug at a terminal of an assembly, and/or
∘ at least one connection plug to the electronic card, and/or
∘ at least one connecting cable for connecting the terminal of the assembly to the electronic card, and/or
∘ at least one sensor.

16. A power storage module including a housing wherein are arranged at least two electrical power storage assemblies, **characterized in that** the module includes a supporting device according to one of the preceding claims, each assembly (3) being positioned in a respective opening and protruding from the plate (1) of the device on either side thereof.

17. The module according to the preceding claim, wherein the, or at least two adjoining assemblies are electrically connected by means of a connection link positioned on two end faces of the assemblies and extending essentially parallel to the plate when the assemblies are placed in the supporting device, **characterized in that** the device includes a connection plug positioned in the chamber as defined in Claims 2 and 3, said connection plug being able to cooperate with a tongue situated protruding from the connection link, essentially perpendicular to the link.

18. A method for manufacturing a module according to Claim 16 or Claim 17, **characterized in that** it includes the following steps:
- insertion of each storage assembly into a respective recess of a supporting device, each assembly (3) protruding from the plate (1) of the device on either side thereof,
- electrical connection of a connection link intended to electrically connect two adjoining storage assemblies to connection means positioned at the supporting device, to electrically connect the connection link to an electronic card of the module,
- soldering the connection link to two adjoining storage assemblies to electrically connect said adjoining storage assemblies.

19. The manufacturing method according to the preceding claim, **characterized in that** it also includes a step consisting of positioning the connection means on the supporting device, said positioning step including:
- placing a connecting cable on a plate of the device using guide means extending perpendicular to the plate,
- placing a connection plug in a chamber of the device,
- electrical connection of the connecting cable to the connection plug.
